# EUROPEAN PATENT APPLICATION

(11) **EP 4 749 917 A1**
(43) Date of publication of application: **27.05.2026**
(21) Application number: 24850682.6
(22) Date of filing: 21.06.2024
(51) Int. Cl.: H03D 7/14, H04B 1/44

(54) **FREQUENCY MIXER AND SIGNAL TRANSMISSION DEVICE**

(30) Priority: 08.08.2023 CN 202310994122
(71) Applicant: Huawei Technologies Co., Ltd., Shenzhen, Guangdong 518129 (CN)
(72) Inventor: LI, Changliang, Shenzhen, Guangdong 518129 (CN); JI, Tengteng, Shenzhen, Guangdong 518129 (CN); LIANG, Bowen, Shenzhen, Guangdong 518129 (CN); ZHOU, Hang, Shenzhen, Guangdong 518129 (CN); WU, Guochun, Shenzhen, Guangdong 518129 (CN); LI, Xuejiao, Shenzhen, Guangdong 518129 (CN); ZHANG, Tao, Shenzhen, Guangdong 518129 (CN)
(74) Representative: Maiwald GmbH
(86) International application number: PCT/CN2024/100592
(87) International publication number: WO 2025/031030

(57) **Abstract**

This application provides a frequency mixer and a signal transmission device, relating to the field of communication technologies. In the solution provided in this application, the frequency mixer can transmit a local oscillator signal through a slot line, and transmit a first signal, a second signal, and a third signal through microstrips. Therefore, it can be ensured that a transmission mode of the local oscillator signal is different from a transmission mode of the first signal, and different from transmission modes of the second signal and the third signal. In other words, isolation between the transmission mode of the local oscillator signal and the transmission mode of the first signal, and isolation between the transmission mode of the local oscillator signal and the transmission modes of the second signal and the third signal can be achieved. Owing to the isolation between the transmission mode of the local oscillator signal and the transmission modes of other signals, local oscillator signal leakage on other signal ports can be effectively reduced, thereby effectively improving performance of the frequency mixer.

## Description

This application claims priority to Chinese Patent Application No. 202310994122.6, filed on August 8, 2023 and entitled "FREQUENCY MIXER AND SIGNAL TRANSMISSION DEVICE", which is incorporated herein by reference in its entirety.

### TECHNICAL FIELD

This application relates to the field of communication technologies, and in particular, to a frequency mixer and a signal transmission device.

### BACKGROUND

A frequency mixer is a key component in microwave systems used for frequency conversion. In receivers, the frequency mixer combines a received radio frequency signal with a received local oscillator signal, to generate an intermediate frequency signal or a baseband signal. In transmitters, the frequency mixer combines a baseband signal (or an intermediate frequency signal) with a local oscillator signal, to generate a radio frequency signal.

However, in a process of mixing signals of different frequencies, the local oscillator signal may be leaked to other signal ports of the frequency mixer, for example, a radio frequency signal port. In other words, the frequency mixer has a problem of local oscillator signal leakage (local oscillator leakage for short). The local oscillator leakage seriously degrades performance of the receiver and the transmitter.

### SUMMARY

This application provides a frequency mixer and a signal transmission device, to resolve a technical problem of serious local oscillator leakage of the frequency mixer.

According to a first aspect, a frequency mixer is provided, where the frequency mixer includes a core circuit, a slot line, a first microstrip, a second microstrip, and a third microstrip. The slot line, the first microstrip, the second microstrip, and the third microstrip are all connected to the core circuit. The slot line is configured to transmit a local oscillator signal to the core circuit, the first microstrip is configured to transmit a first signal of a first frequency, the second microstrip is configured to transmit a second signal of a second frequency, and the third microstrip is configured to transmit a third signal of the second frequency. The second frequency is different from the first frequency, and a phase of the third signal is opposite to a phase of the second signal. The core circuit is configured to perform frequency conversion between the first frequency and the second frequency based on the local oscillator signal.

The frequency mixer provided in this application can transmit the local oscillator signal through the slot line, and transmit the first signal and the second signal through the microstrips. Therefore, it can be ensured that a transmission mode of the local oscillator signal is different from a transmission mode of the first signal, and is different from transmission modes of the second signal and the third signal. In other words, the transmission mode of the local oscillator signal is isolated from the transmission mode of the first signal, and is isolated from the transmission modes of the second signal and the third signal. Because the transmission mode of the local oscillator signal is isolated from the transmission modes of other signals, local oscillator signal leakage on other signal ports can be effectively reduced, thereby effectively improving performance of the frequency mixer.

Optionally, the core circuit may include a first transistor and a second transistor, where a first electrode of the first transistor is connected to a first electrode of the second transistor. One side of the slot line is connected to a gate of the first transistor, and the other side of the slot line is connected to a gate of the second transistor. The first microstrip is connected to the first electrode of the first transistor, the second microstrip is connected to a second electrode of the first transistor, and the third microstrip is connected to a second electrode of the second transistor.

It may be understood that the slot line includes two spaced metal plates (or metal lines). One side of the slot line is one of the two metal plates (or metal lines), and the other side of the slot line is the other metal plate (or metal line). It may be further understood that a first electrode of a transistor may be one of a source and a drain, and a second electrode of the transistor may be the other of the source and the drain.

The two sides of the slot line are connected to the gates of the two transistors, so that differential feeding of the local oscillator signal can be implemented. In other words, the local oscillator signal fed into the core circuit is a differential signal. A double-feeding structure of the gates can ensure that even if the local oscillator signal is leaked to another signal port (for example, a radio frequency signal port) of the frequency mixer, a phase of the leaked signal is opposite and energy is canceled, thereby effectively improving local oscillator rejection.

Optionally, the first transistor and the second transistor may be field-effect transistors. Using the field-effect transistor as a nonlinear unit of the frequency mixer can ensure high linearity.

The field-effect transistor may be a transistor with a high electron mobility and a low knee voltage, to further ensure that frequency conversion efficiency and the linearity of the frequency mixer are high.

Optionally, the slot line, the gate of the first transistor, and the gate of the second transistor may be located at a same layer, and may be made of a same metal material. Therefore, a preparation process of the frequency mixer can be effectively simplified, and preparation efficiency of the frequency mixer can be improved.

Optionally, a strip conductor of the first microstrip, a strip conductor of the second microstrip, a strip conductor of the third microstrip, the first electrode and the second electrode of the first transistor, and the first electrode and the second electrode of the second transistor may all be located at a same layer, and may be made of a same metal material.

It may be understood that the microstrip may include a strip conductor located on the top of a dielectric substrate and a ground (ground, GND) plane located below the dielectric substrate. In the solution provided in this application, the slot line, the strip conductors of the microstrips, and the electrodes of the transistors may be located at a same layer, and may be made of a same metal material. Therefore, a preparation process of the frequency mixer can be effectively simplified, and preparation efficiency of the frequency mixer can be improved.

Optionally, the frequency mixer may further include a fourth microstrip, where the fourth microstrip is connected to the slot line, and is configured to transmit the local oscillator signal to the slot line. The local oscillator signal transmitted by the fourth microstrip may be a single-end signal. After being fed into the slot line, the single-end signal may be converted into a differential signal. In other words, the transmission mode of the local oscillator signal can be changed from a microstrip primary transmission mode to a slot-line primary transmission mode, to change an electromagnetic field transmission mode.

Optionally, the slot line may also be directly connected to a local oscillator port, and is configured to receive a local oscillator signal output by the local oscillator port, where the local oscillator signal output by the local oscillator port is a differential signal.

By directly feeding the differential local oscillator signal, there is no need to transmit the local oscillator signal from a microstrip to the slot line and convert the signal transmission mode, thereby effectively simplifying a structure of the frequency mixer.

Optionally, the first signal may be a radio frequency signal, and both the second signal and the third signal may be intermediate frequency signals; or the first signal may be an intermediate frequency signal, and the second signal and the third signal may be radio frequency signals. Correspondingly, the frequency mixer can implement frequency conversion between a radio frequency signal and an intermediate frequency signal. The intermediate frequency signal may further include a zero intermediate frequency signal, that is, a baseband signal. In other words, the frequency mixer can be used in a zero intermediate frequency architecture.

Optionally, the first microstrip may be configured to transmit the first signal to the core circuit, the second microstrip is configured to transmit the second signal output by the core circuit, and the third microstrip is configured to transmit the third signal output by the core circuit. That is, the first signal may be an input signal, and the second signal and the third signal may be output signals.

Alternatively, the first microstrip is configured to transmit the first signal output by the core circuit, the second microstrip is configured to transmit the second signal to the core circuit, and the third microstrip is configured to transmit the third signal to the core circuit. That is, both the second signal and the third signal may be input signals, and the first signal may be an output signal.

It may be understood that, if the radio frequency signal is an input signal, and the intermediate frequency signal is an output signal, the frequency mixer is configured to down-convert the radio frequency signal, that is, the frequency mixer can work as a down-converter. In this case, the input radio frequency signal can drive a transistor in the core circuit of the frequency mixer to generate a channel current.

If the intermediate frequency signal is an input signal, and the radio frequency signal is an output signal, the frequency mixer is configured to up-convert the intermediate frequency signal, that is, the frequency mixer can work as an up-converter. In this case, the input intermediate frequency signal can drive a transistor in the core circuit of the frequency mixer to generate a channel current.

Optionally, the frequency mixer may further include at least one of a first frequency selective circuit, a second frequency selective circuit, a third frequency selective circuit, and a fourth frequency selective circuit. The first frequency selective circuit is connected to the slot line, the second frequency selective circuit is connected to the first microstrip, the third frequency selective circuit is connected to the second microstrip, and the fourth frequency selective circuit is connected to the third microstrip.

If the frequency mixer includes a fourth microstrip, the first frequency selective circuit may be connected to the slot line through the fourth microstrip. The first frequency selective circuit can implement matching the local oscillator signal, and open-circuit of the first signal, the second signal, and the third signal. The second frequency selective circuit can implement matching of the first signal, open-circuit of the local oscillator signal, and short-circuit of the second signal and the third signal. The third frequency selective circuit and the fourth frequency selective circuit can implement matching of the second signal and the third signal, open-circuit of the local oscillator signal, and short-circuit of the first signal.

In the solution provided in this application, because the transmission mode of the local oscillator signal is isolated from the transmission mode of the first signal, and is isolated from the transmission modes of the second signal and the third signal, complexity of matching signal ports of the frequency mixer can be effectively reduced, so that the signal ports do not need to use a frequency selective circuit with a high rejection ratio. Therefore, structural complexity and an area of each frequency selective circuit can be effectively reduced, thereby saving a chip area and costs of the frequency mixer. For example, an area and costs of the frequency mixer provided in embodiments of this application can be reduced by about 30% compared with those in a case in which the local oscillator signal, the first signal, the second signal, and the third signal are transmitted through microstrips.

According to a second aspect, a signal transmission device is provided. The signal transmission device may include an antenna and the frequency mixer provided according to the first aspect. The frequency mixer is configured to perform frequency conversion on a signal received by the antenna, and/or the frequency mixer is configured to: transmit a frequency-converted signal to the antenna and radiate the signal through the antenna.

If the frequency mixer is an up-converter, the frequency mixer can up-convert a baseband signal or an intermediate frequency signal into a radio frequency signal, and transmit the radio frequency signal to the antenna for radiation by the antenna. If the frequency mixer is a down-converter, the frequency mixer can down-convert the radio frequency signal received by the antenna into an intermediate frequency signal or a baseband signal. Because the frequency mixer provided in the foregoing aspect can effectively reject local oscillator signal leakage, it can be ensured that signal transmission performance of the signal transmission device is good.

In conclusion, this application provides a frequency mixer and a signal transmission device. The frequency mixer can transmit a local oscillator signal through a slot line, and transmit a second signal and a third signal through microstrips. Therefore, it can be ensured that a transmission mode of the local oscillator signal is different from a transmission mode of the first signal, and is different from transmission modes of the second signal and the third signal. In other words, the transmission mode of the local oscillator signal is isolated from the transmission mode of the first signal, and is isolated from the transmission modes of the second signal and the third signal. Because an electromagnetic field signal transmission mode of the local oscillator signal is isolated from electromagnetic field signal transmission modes of other signals, local oscillator signal leakage on other signal ports can be effectively reduced, thereby effectively improving performance of the frequency mixer.

### BRIEF DESCRIPTION OF DRAWINGS

FIG. 1 is a diagram of a structure of a signal transmission device according to an embodiment of this application;
FIG. 2 is a diagram of a structure of a frequency mixer according to an embodiment of this application;
FIG. 3 is a diagram of transmission modes of signals in a frequency mixer according to an embodiment of this application;
FIG. 4 is a diagram of a structure of a core circuit of a frequency mixer according to an embodiment of this application;
FIG. 5 is a diagram of a structure of another frequency mixer according to an embodiment of this application; and
FIG. 6 is a diagram of a structure of still another frequency mixer according to an embodiment of this application.

### DESCRIPTION OF EMBODIMENTS

The following describes in detail a frequency mixer and a signal transmission device provided in embodiments of this application with reference to the accompanying drawings.

The frequency mixer provided in embodiments of this application may be used in the signal transmission device. The signal transmission device may be configured to transmit a microwave signal, and therefore may also be referred to as a microwave transmission device. For example, the signal transmission device may be configured to transmit a radio frequency signal, that is, the signal transmission device may be a radio frequency receiver, a radio frequency transmitter, or a radio frequency transceiver.

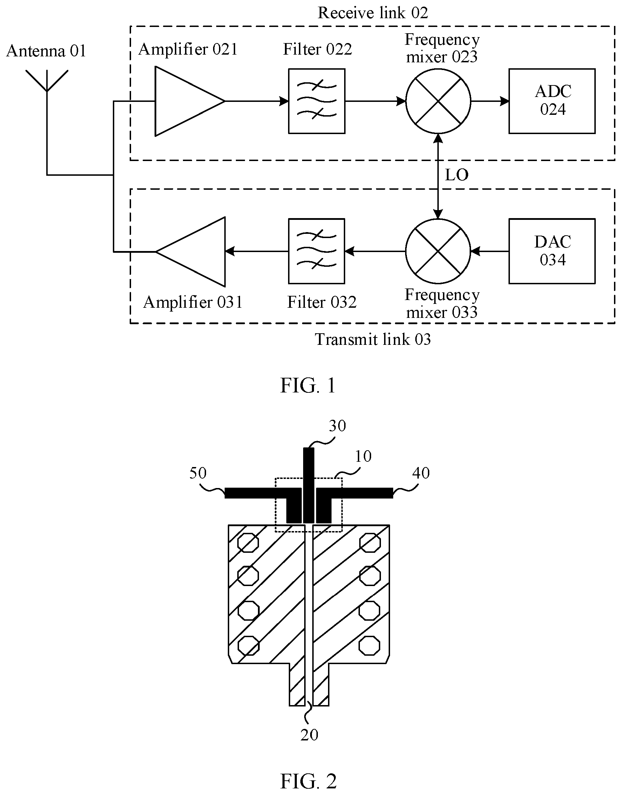

FIG. 1 is a diagram of a structure of a signal transmission device according to an embodiment of this application, and in FIG. 1, an example in which the signal transmission device is a radio frequency transceiver device is used for description. As shown in FIG. 1, the signal transmission device may include an antenna 01, a receive link 02, and a transmit link 03. The receive link 02 may include an amplifier 021, a filter 022, a frequency mixer 023, and an analog-to-digital converter (analog-to-digital converter, ADC) 024. The amplifier 021 may be a low noise amplifier (low noise amplifier, LNA), and is configured to amplify a radio frequency (radio frequency, RF) signal received by the antenna 01. The filter 022 is configured to filter the radio frequency signal. The frequency mixer 023 is configured to down-convert the radio frequency signal based on a local oscillator (local oscillator, LO) signal, to obtain an intermediate frequency (intermediate frequency, IF) signal or a baseband signal. The ADC 024 is configured to perform analog-to-digital conversion on an analog signal output by the frequency mixer 023, to obtain a digital signal, and transmit the converted digital signal to a baseband chip (not shown in the figure).

Still refer to FIG. 1. Over the transmit link 03, there may be an amplifier 031, a filter 032, a frequency mixer 033, and a digital-to-analog converter (digital-to-analog converter, DAC) 034. The DAC 034 is configured to perform digital-to-analog conversion on a to-be-transmitted digital baseband signal transmitted by the baseband chip, to obtain an analog baseband signal. The frequency mixer 033 is configured to up-convert the analog baseband signal based on the local oscillator signal, to obtain a radio frequency signal. The filter 032 is configured to filter the radio frequency signal. The amplifier 031 may be a power amplifier (power amplifier, PA). The power amplifier is configured to: amplify power of the received radio frequency signal, and transmit the power-amplified radio frequency signal to the antenna 01. The antenna 01 may further radiate the received radio frequency signal.

The antenna 01 may include a receive antenna and a transmit antenna. The receive antenna is connected to the receive link 02, and is configured to receive a radio frequency signal transmitted by another device. The transmit antenna is connected to the transmit link 03, and is configured to radiate the radio frequency signal to space.

It may be understood that the signal transmission device provided in embodiments of this application may be a signal receiving device (also referred to as a receiver). Correspondingly, the signal transmission device may not include the transmit link 03. Alternatively, the signal transmission device provided in embodiments of this application may be a signal transmit device (also referred to as a transmitter). Correspondingly, the signal transmission device may not include the receive link 02.

It may be further understood that in the signal transmission device, the receive link 02 and/or the transmit link 03 may further include other signal processor components, for example, may further include more amplifiers, filters, and/or frequency mixers. Certainly, the signal processing components included in the receive link 02 and/or in the transmit link 03 may also be reduced based on a requirement in an application scenario, and a connection relationship between the signal processing components may also be flexibly adjusted based on a requirement in the application scenario. This is not limited in embodiments of this application.

For example, if the signal transmission device uses a zero intermediate frequency architecture, the frequency mixer 023 and the frequency mixer 033 may implement frequency conversion between the radio frequency signal and the baseband signal. If the signal transmission device uses a superheterodyne architecture, the receive link 02 and the transmit link 03 may each include at least two frequency mixers. One of the two frequency mixers may be configured to implement frequency conversion between the radio frequency signal and an intermediate frequency signal, and the other frequency mixer may be configured to implement frequency conversion between the intermediate frequency signal and the baseband signal.

For the receive link, if the zero intermediate frequency architecture is used, in a scenario of 1+1 module hot backup, a local oscillator signal of a backup module may be fed into a receive end of an operating module through a combiner unit, causing co-channel interference, and affecting sensitivity of the receiver. The 1+1 module hot backup may mean that a primary receiver and a secondary receiver are deployed in a system. The backup module may be the secondary receiver, and the operating module may be the primary receiver.

On the transmit link, local oscillator signal leakage affects transmit detection power precision, and additional quadrature modulation compensation (orthogonal modulation compensation, QMC) algorithm correction or equipment correction is required to improve device performance. It can be learned from the foregoing analysis that a hardware implementation solution for reducing or rejecting the local oscillator signal leakage is very important to improve performance of the signal transmission device.

In some embodiments, an image rejection (image rejection) frequency mixer can utilize two 90-degree bridges at radio frequency and intermediate frequency to produce 180-degree reverse cancellation on two channels of image signals. Although the image rejection frequency mixer can reject image frequency interference energy, it cannot suppress local oscillator leakage.

In some other embodiments, a local oscillator rejection (LO rejection) frequency mixer can implement local oscillator power energy cancellation on a radio frequency port by applying 180-degree phase shift on the local oscillator signal, thereby providing an additional rejection function of the local oscillator signal. However, a core (mixer core) circuit of the local oscillator rejection frequency mixer does not have the rejection function of the local oscillator signal, and consequently cannot effectively suppress the local oscillator signal leakage.

The core circuit of the frequency mixer is a nonlinear circuit for frequency conversion in the frequency mixer, and the nonlinear circuit may include one or more non-linear elements. A region in which the core circuit is located may also be referred to as a core region.

FIG. 2 is a diagram of a structure of a frequency mixer according to an embodiment of this application, and the frequency mixer may be used in the signal transmission device shown in FIG. 1. For example, the frequency mixer may be configured to perform frequency mixing on a local oscillator signal and a radio frequency signal to obtain an intermediate frequency signal; or the frequency mixer may be configured to perform frequency mixing on a local oscillator signal and an intermediate frequency signal to obtain a radio frequency signal. The frequency mixer provided in embodiments of this application may effectively reduce an amount of local oscillator signal leakage and improve component performance.

As shown in FIG. 2, the frequency mixer may include a core circuit 10, a slot line (slot line) 20, a first microstrip (micro-strip) 30, a second microstrip 40, and a third microstrip 50. The slot line 20, the first microstrip 30, the second microstrip 40, and the third microstrip 50 are all connected to the core circuit 10.

In this embodiment of this application, the slot line 20 may be configured to transmit the local oscillator signal to the core circuit 10, the first microstrip 30 may be configured to transmit a first signal of a first frequency, the second microstrip 40 may be configured to transmit a second signal of a second frequency, and the third microstrip 50 may be configured to transmit a third signal of the second frequency. The core circuit 10 may be configured to implement, based on the received local oscillator signal, frequency conversion between the first frequency and the second frequency. The second frequency is different from the first frequency, and a phase of the third signal is opposite to a phase of the second signal, that is, a phase difference between the third signal and the second signal may be 180 degrees.

In an optional implementation, the first microstrip 30 may be configured to transmit the first signal to the core circuit 10, the second microstrip 40 may be configured to transmit the second signal output by the core circuit 10, and the third microstrip 50 may be configured to transmit the third signal output by the core circuit 10. That is, the first signal may be an input signal, and the second signal and the third signal may be output signals. Correspondingly, the core circuit 10 can perform frequency mixing on the local oscillator signal and the first signal, to obtain the second signal and the third signal.

In another optional implementation, the first microstrip 30 may be configured to transmit the first signal output by the core circuit 10, the second microstrip 40 may be configured to transmit the second signal to the core circuit 10, and the third microstrip 50 may be configured to transmit the third signal to the core circuit 10. That is, both the second signal and the third signal may be input signals, and the first signal may be an output signal. Correspondingly, the core circuit 10 can perform frequency mixing on the local oscillator signal, the second signal, and the third signal, to obtain the first signal.

It may be understood that the first frequency may be greater than the second frequency. For example, the first signal may be a radio frequency signal, and the second signal and the third signal may be intermediate frequency signals. Alternatively, the first frequency may be less than the second frequency. For example, the first signal may be an intermediate frequency signal, and the second signal and the third signal may be radio frequency signals.

In embodiments of this application, if the radio frequency signal is an input signal, and the intermediate frequency signal is an output signal, the frequency mixer can down-convert the radio frequency signal based on the local oscillator signal, to obtain the intermediate frequency signal. Correspondingly, the frequency mixer may be a down-converter. Alternatively, if the intermediate frequency signal is an input signal, and the radio frequency signal is an output signal, the frequency mixer can up-convert the intermediate frequency signal based on the local oscillator signal, to obtain the radio frequency signal. Correspondingly, the frequency mixer may be an up-converter.

It may be further understood that the intermediate frequency signal in embodiments of this application may further include a zero intermediate frequency signal, that is, a baseband signal. In other words, the frequency mixer may implement frequency conversion between the radio frequency signal and the baseband signal, that is, the frequency mixer may be further used in a zero intermediate frequency architecture. If the frequency mixer is configured to implement frequency conversion between the radio frequency signal and the intermediate frequency signal, or frequency conversion between the intermediate frequency signal and the baseband signal, the frequency mixer can be used in a superheterodyne architecture.

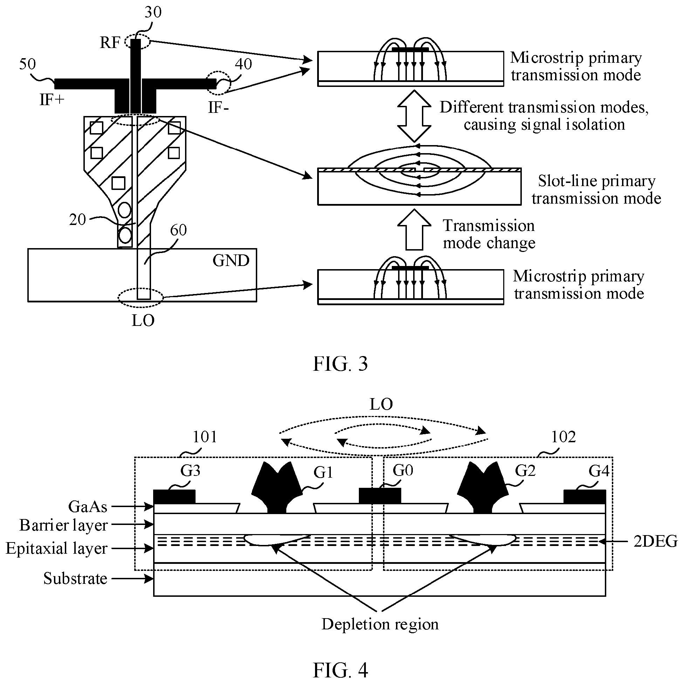

FIG. 3 is a diagram of transmission modes of signals in a frequency mixer according to an embodiment of this application. As shown in FIG. 3, in a region (that is, a core region of the frequency mixer) in which the core circuit 10 is located, the local oscillator signal is transmitted in a slot-line primary mode, and the first signal, the second signal, and the third signal (that is, a radio frequency signal and intermediate frequency signals) are transmitted in a microstrip primary mode. In the region in which the core circuit 10 is located, electric field distribution of the local oscillator signal may be shown by dashed arrows in FIG. 4.

With reference to FIG. 3 and FIG. 4, it can be learned that an electromagnetic field transmission mode of the local oscillator signal is orthogonal to a transmission mode of the radio frequency signal, and is orthogonal to transmission modes of the intermediate frequency signals. Therefore, it can be ensured that the local oscillator signal is not coupled to the radio frequency signal, and is not coupled to the intermediate frequency signal. That is, energy of the local oscillator signal may be isolated from energy of other signals, thereby effectively reducing local oscillator leakage of a frequency mixer core.

Table 1 shows test results obtained by performing simulation tests on an image rejection frequency mixer, a local oscillator rejection frequency mixer, and the frequency mixer provided in this embodiment of this application. As shown in Table 1, in an 80 gigahertz (GHz) band, neither the image rejection frequency mixer nor the local oscillator rejection frequency mixer can isolate the local oscillator signal in the core region of the frequency mixer, that is, local oscillator isolation of the image rejection frequency mixer and local oscillator isolation of the local oscillator rejection frequency mixer are both 0 decibels (dB). However, the frequency mixer provided in embodiments of this application can improve isolation by more than 10 dB. It can be learned from the simulation results that the frequency mixer provided in embodiments of this application has a good local oscillator rejection effect in the core region, and can effectively reduce an amount of local oscillator signal leakage.

**Table 1**

| Frequency mixer core solution | Band | Local oscillator isolation |
|---|---|---|
| Image rejection frequency mixer | | 0 dB |
| Local oscillator rejection frequency mixer | 80 GHz | 0 dB |
| Solution in this embodiment of this application | | > 10 dB |

In conclusion, embodiments of this application provide a frequency mixer. The frequency mixer can transmit the local oscillator signal through the slot line, and transmit the first signal, the second signal, and the third signal through the microstrips. Therefore, it can be ensured that the transmission mode of the local oscillator signal is different from a transmission mode of the first signal, and is different from transmission modes of the second signal and the third signal. In other words, the transmission mode of the local oscillator signal is isolated (mode isolation) from the transmission mode of the first signal, and is isolated from the transmission modes of the second signal and the third signal. Because an electromagnetic field signal transmission mode of the local oscillator signal is isolated from electromagnetic field signal transmission modes of other signals, the local oscillator signal leakage on other signal ports can be effectively reduced, thereby effectively improving performance of the frequency mixer.

FIG. 4 is a diagram of a structure of a core circuit according to an embodiment of this application. As shown in FIG. 4, the core circuit 10 may include a first transistor 101 and a second transistor 102. A first electrode of the first transistor 101 is connected to a first electrode of the second transistor 102, and a common end formed by the first electrodes of the two transistors may be shown as G0 in FIG. 4.

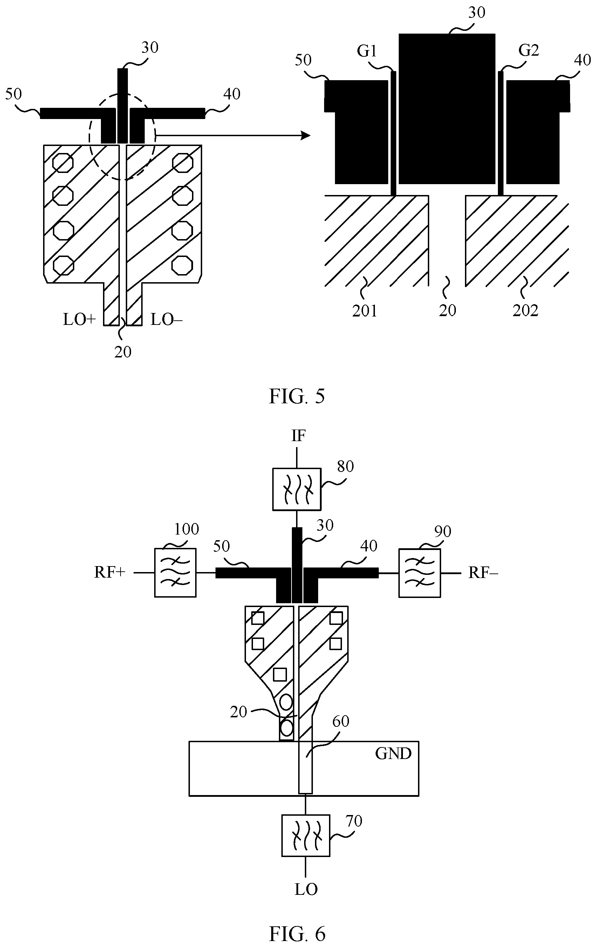

FIG. 5 is a diagram of a partial structure of a core circuit according to an embodiment of this application. With reference to FIG. 4 and FIG. 5, it can be learned that one side 201 of the slot line 20 may be connected to a gate G1 of the first transistor 101, and the other side 202 of the slot line 20 may be connected to a gate G2 of the second transistor 102. In addition, the first microstrip 30 may be connected to the first electrode of the first transistor 101, that is, the first microstrip 30 may be connected to the common end G0 of the two transistors. The second microstrip 40 may be connected to a second electrode G3 of the first transistor 101, and the third microstrip 50 may be connected to a second electrode G4 of the second transistor 102.

It may be understood that the slot line 20 includes two spaced metal plates (or metal lines). One side 201 of the slot line 20 is one of the two metal plates (or metal lines), and the other side 202 of the slot line 20 is the other metal plate (or metal line). It may be further understood that a first electrode of a transistor may be one of a source and a drain, and a second electrode of the transistor may be the other of the source and the drain. This is not limited in embodiments of this application.

Optionally, in embodiments of this application, the first transistor 101 and the second transistor 102 may be field-effect transistors (field-effect transistor, FET). Using the FET as a nonlinear unit of the frequency mixer can ensure high linearity of the frequency mixer.

FETs with a high electron mobility and a low knee voltage may further be selected as the first transistor 101 and the second transistor 102, to further ensure that frequency conversion efficiency and the linearity of the frequency mixer are high.

As shown in FIG. 4, the first transistor 101 and the second transistor 102 may be formed on a substrate, and the substrate may be a gallium arsenide (GaAs) substrate. In addition, the transistors may further include an epitaxial layer, a barrier layer, and an electrode layer that are sequentially formed on the substrate. The epitaxial layer may be a GaAs epitaxy, to ensure good material consistency. A material of the barrier layer may be aluminum gallium arsenide (ALGaAs). A material of the electrode layer may be a metal material, and the electrode layer may include the gates, the first electrodes, and the second electrodes of the transistors. In addition, a heavily doped GaAs layer may be further formed between the electrode layer and the barrier layer.

Still refer to FIG. 4. A two-dimensional electron gas (2DEG) is further formed in the epitaxial layer, and depletion regions, that is, channel regions, of the transistors are formed in the epitaxial layer. The local oscillator signal is loaded on the two gates through the planar slot line 20, so as to control channel statuses of the two transistors. It may also be understood as that a voltage of the slot line 20 can control the channel statuses of the transistors.

In this embodiment of this application, when the frequency mixer works as an up-converter, an intermediate frequency signal and a local oscillator signal are input signals, and a radio frequency signal is an output signal. In this case, the intermediate frequency signal can drive the first transistor 101 and the second transistor 102 to generate a channel current. When the frequency mixer works as a down-converter, a radio frequency signal and a local oscillator signal are input signals, and an intermediate frequency signal is an output signal. In this case, the radio frequency signal can drive the first transistor 101 and the second transistor 102 to generate a channel current.

Refer to FIG. 3. It may be understood that the first microstrip 30 may be configured to transmit a radio frequency signal RF, the second microstrip 40 may be configured to transmit an intermediate frequency signal IF-, and the third microstrip 50 may be configured to transmit an intermediate frequency signal IF+. That is, the common end in the middle of the two transistors may be used as an output end or an input end of the radio frequency signal RF, and the left electrode and the right electrode of the two transistors may be used as input ends or output ends of the intermediate frequency signals IF.

Alternatively, refer to FIG. 6. The first microstrip 30 may be configured to transmit an intermediate frequency signal IF, the second microstrip 40 may be configured to transmit a radio frequency signal RF-, and the third microstrip 50 may be configured to transmit a radio frequency signal RF+. That is, the common end in the middle of the two transistors may be used as an output end or an input end of the intermediate frequency signal IF, and the left electrode and the right electrode of the two transistors may be used as input ends or output ends of the radio frequency signals RF.

Optionally, as shown in FIG. 5, the slot line 20, the gate G1 of the first transistor 101, and the gate G2 of the second transistor 102 may be located at a same layer, and may be made of a same metal material. Therefore, a preparation process of the frequency mixer can be effectively simplified, and preparation efficiency of the frequency mixer can be improved.

It may be understood that a microstrip may include a strip conductor located on the top of a dielectric substrate and a ground plane located below the dielectric substrate. In this embodiment of this application, a strip conductor of the first microstrip 30, a strip conductor of the second microstrip 40, a strip conductor of the second microstrip 40, the first electrode and the second electrode of the first transistor 101, and the first electrode and the second electrode of the second transistor 102 may be all located at a same layer, and may be made of a same metal material.

For example, refer to FIG. 4 and FIG. 5. The slot line 20, the strip conductors of the microstrips, and the electrodes of the transistors in the core circuit 10 may be located at a same layer, and may be made of a same metal material. Therefore, the preparation process of the frequency mixer can be effectively simplified, and the preparation efficiency of the frequency mixer can be improved.

In a first optional implementation, as shown in FIG. 3, the frequency mixer may further include a fourth microstrip 60. The fourth microstrip 60 may be connected to the slot line 20, and is configured to transmit the local oscillator signal to the slot line 20. In other words, one end of the slot line 20 is connected to the fourth microstrip 60, and the other end is connected to the core circuit 10. The local oscillator signal transmitted by the fourth microstrip 60 may be a single-end signal. After being fed into the slot line 20, the single-end signal may be converted into a differential signal. The slot line 20 may further feed the differential local oscillator signal into the core circuit 10.

Based on the foregoing analysis and FIG. 3, it can be learned that the transmission mode of the local oscillator signal can be changed from a microstrip primary transmission mode to a slot-line primary transmission mode, to change the electromagnetic field transmission mode.

In a second optional implementation, refer to FIG. 5. The slot line 20 may be directly connected to a local oscillator port (not shown in the figure), and is configured to receive a local oscillator signal output by the local oscillator port, where the local oscillator signal output by the local oscillator port is a differential signal. As shown in FIG. 5, the differential signal includes a signal LO+ and a signal LO-, and phases of the signal LO+ and the signal LO- are opposite.

By directly feeding the differential local oscillator signal, there is no need to transmit the local oscillator signal from a microstrip to the slot line and convert the signal transmission mode, thereby effectively simplifying a structure of the frequency mixer.

Based on the foregoing two implementations, it can be learned that, in embodiments of this application, the two sides of the slot line 20 are connected to the gates of the two transistors, so that differential feeding of the local oscillator signal can be implemented. In other words, the local oscillator signal fed into the core circuit 10 is a differential signal. In this way, common mode rejection can be provided. Even if the local oscillator signal is leaked to another signal port (for example, a radio frequency signal port) of the frequency mixer, a phase of the leaked local oscillator signal is opposite and energy is canceled, thereby effectively improving local oscillator rejection.

As shown in FIG. 6, the frequency mixer may further include at least one of a first frequency selective circuit 70, a second frequency selective circuit 80, a third frequency selective circuit 90, and a fourth frequency selective circuit 100. For example, the frequency mixer shown in FIG. 6 includes the first frequency selective circuit 70, the second frequency selective circuit 80, the third frequency selective circuit 90, and the fourth frequency selective circuit 100.

The first frequency selective circuit 70 is connected to an end that is of the slot line 20 and that is away from the core circuit 10. If the frequency mixer further includes the fourth microstrip 60, the first frequency selective circuit 70 may be connected to the slot line 20 through the fourth microstrip 60. The second frequency selective circuit 80 is connected to an end that is of the first microstrip 30 and that is away from the core circuit 10, the third frequency selective circuit 90 is connected to an end that is of the second microstrip 40 and that is away from the core circuit 10, and the fourth frequency selective circuit 100 is connected to an end that is of the third microstrip 50 and that is away from the core circuit 10.

It may be understood that a frequency selective circuit may also be referred to as a frequency selection network, a frequency selection circuit, or a matching network, and is configured to implement signal matching. For example, refer to FIG. 6. Each of the first frequency selective circuit 70, the second frequency selective circuit 80, the third frequency selective circuit 90, and the fourth frequency selective circuit 100 may include at least one filter. Certainly, the frequency selective circuit may further include another signal processing component. This is not limited in embodiments of this application.

It may be further understood that, the first frequency selective circuit 70 connected to the slot line 20 can implement matching (match) of the local oscillator signal, and open-circuit (open) of the first signal, the second signal, and the third signal. The second frequency selective circuit 80 connected to the first microstrip 30 can implement matching of the first signal, open-circuit of the local oscillator signal, and short-circuit (short) of the second signal and the third signal. The third frequency selective circuit 90 connected to the second microstrip 40 and the fourth frequency selective circuit 100 connected to the third microstrip 50 can implement matching of the second signal and the third signal, open-circuit of the local oscillator signal, and short-circuit of the first signal.

In embodiments of this application, because the transmission mode of the local oscillator signal is isolated from the transmission mode of the first signal, and is isolated from the transmission modes of the second signal and the third signal, complexity of matching signal ports of the frequency mixer can be effectively reduced, so that the signal ports do not need to use a frequency selective circuit with a high rejection ratio. Therefore, structural complexity and an area of each frequency selective circuit can be effectively reduced, thereby saving a chip area and costs of the frequency mixer. For example, an area and costs of the frequency mixer provided in embodiments of this application can be reduced by about 30% compared with those in a case in which the local oscillator signal, the first signal, the second signal, and the third signal are transmitted through microstrips.

In conclusion, embodiments of this application provide a frequency mixer. The frequency mixer can transmit the local oscillator signal through the slot line, and transmit the first signal, the second signal, and the third signal through the microstrips. Therefore, it can be ensured that the transmission mode of the local oscillator signal is different from the transmission mode of the first signal, and is different from the transmission modes of the second signal and the third signal. In other words, the transmission mode of the local oscillator signal is isolated from the transmission mode of the first signal, and is isolated from the transmission modes of the second signal and the third signal. Because the electromagnetic field signal transmission mode of the local oscillator signal is isolated from the electromagnetic field signal transmission modes of other signals, the local oscillator signal leakage on other signal ports can be effectively reduced, thereby effectively improving performance of the frequency mixer.

In addition, the frequency mixer can further use an FET as a nonlinear unit, thereby effectively improving frequency conversion efficiency and linearity of the frequency mixer. In addition, because mode isolation between the local oscillator signal and other signals is implemented, structural complexity of the frequency selective circuits in the frequency mixer can further be effectively reduced, thereby reducing the area and the costs of the frequency mixer.

It may be understood that, because the frequency mixer provided in embodiments of this application can effectively reject local oscillator leakage in the core region (theoretically, 100% bandwidth local oscillator rejection at both the radio frequency port and an intermediate frequency port can be implemented), the frequency mixer can be used in design and development of a multiband wide frequency component. For example, the frequency mixer may be used in a design of a microwave ultra-high frequency broadband circuit, so as to ensure high receiving efficiency of microwave ultra-high frequency radiation and a good mode isolation effect.

In embodiments of this application, the terms "first", "second", and "third" are merely used for description, but shall not be understood as an indication or implication of relative importance. The term "at least one" means one or more, and "a plurality of" means two or more.

The term "and/or" in this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

The foregoing descriptions are merely optional implementations of this application, but the protection scope of this application is not limited thereto. Any equivalent modification or replacement readily figured out by a person skilled in the art within the technical scope disclosed in this application shall fall within the protection scope of this application. Therefore, the protection scope of this application shall be subject to the protection scope of the claims.

## Claims

1. A frequency mixer, wherein the frequency mixer comprises a core circuit, a slot line, a first microstrip, a second microstrip, and a third microstrip, wherein
the slot line, the first microstrip, the second microstrip, and the third microstrip are all connected to the core circuit;
the slot line is configured to transmit a local oscillator signal to the core circuit, the first microstrip is configured to transmit a first signal of a first frequency, the second microstrip is configured to transmit a second signal of a second frequency, the third microstrip is configured to transmit a third signal of the second frequency, the second frequency is different from the first frequency, and a phase of the third signal is opposite to a phase of the second signal; and
the core circuit is configured to perform frequency conversion between the first frequency and the second frequency based on the local oscillator signal.

2. The frequency mixer according to claim 1, wherein the core circuit comprises a first transistor and a second transistor, wherein a first electrode of the first transistor is connected to a first electrode of the second transistor;
one side of the slot line is connected to a gate of the first transistor, and the other side of the slot line is connected to a gate of the second transistor; and
the first microstrip is connected to the first electrode of the first transistor, the second microstrip is connected to a second electrode of the first transistor, and the third microstrip is connected to a second electrode of the second transistor.

3. The frequency mixer according to claim 2, wherein the first transistor and the second transistor are field-effect transistors.

4. The frequency mixer according to claim 2 or 3, wherein the slot line, the gate of the first transistor, and the gate of the second transistor are located at a same layer.

5. The frequency mixer according to any one of claims 2 to 4, wherein a strip conductor of the first microstrip, a strip conductor of the second microstrip, a strip conductor of the third microstrip, the first electrode and the second electrode of the first transistor, and the first electrode and the second electrode of the second transistor are all located at a same layer.

6. The frequency mixer according to any one of claims 1 to 5, wherein the frequency mixer further comprises a fourth microstrip, wherein
the fourth microstrip is connected to the slot line, and is configured to transmit the local oscillator signal to the slot line.

7. The frequency mixer according to any one of claims 1 to 5, wherein the slot line is connected to a local oscillator port, and is configured to receive the local oscillator signal output by the local oscillator port, wherein the local oscillator signal output by the local oscillator port is a differential signal.

8. The frequency mixer according to any one of claims 1 to 7, wherein the first signal is a radio frequency signal, and the second signal and the third signal are both intermediate frequency signals; or
the first signal is an intermediate frequency signal, and the second signal and the third signal are both radio frequency signals.

9. The frequency mixer according to any one of claims 1 to 8, wherein the first microstrip is configured to transmit the first signal to the core circuit, the second microstrip is configured to transmit the second signal output by the core circuit, and the third microstrip is configured to transmit the third signal output by the core circuit; or
the first microstrip is configured to transmit the first signal output by the core circuit, the second microstrip is configured to transmit the second signal to the core circuit, and the third microstrip is configured to transmit the third signal to the core circuit.

10. The frequency mixer according to any one of claims 1 to 9, wherein the frequency mixer further comprises at least one of a first frequency selective circuit, a second frequency selective circuit, a third frequency selective circuit, and a fourth frequency selective circuit, wherein
the first frequency selective circuit is connected to the slot line, the second frequency selective circuit is connected to the first microstrip, the third frequency selective circuit is connected to the second microstrip, and the fourth frequency selective circuit is connected to the third microstrip.

11. A signal transmission device, wherein the signal transmission device comprises an antenna and the frequency mixer according to any one of claims 1 to 10, wherein
the frequency mixer is configured to perform frequency conversion on a signal received by the antenna, and/or the frequency mixer is configured to transmit a frequency-converted signal to the antenna.
